# EUROPÄISCHE PATENTSCHRIFT

(11) **EP 2 661 772 B1**
(45) Veröffentlichungstag und Bekanntmachung des Hinweises auf die Patenterteilung: **17.10.2018**
(21) Anmeldenummer: 11808236.1
(22) Anmeldetag: 29.12.2011
(51) Int. Cl.: H01L 25/075, H01L 33/50, H01L 33/58

(54) **LED-ANORDNUNG ZUR ERZEUGUNG VON WEIßEM LICHT**
LED ARRANGEMENT FOR GENERATING WHITE LIGHT
ENSEMBLE DEL DESTINÉ À PRODUIRE UNE LUMIÈRE BLANCHE

(30) Priorität: 04.01.2011 DE 202011000007 U
(43) Veröffentlichungstag der Anmeldung: 13.11.2013
(73) Patentinhaber: Zumtobel Lighting GmbH, 6850 Dornbirn (AT)
(72) Erfinder: KELLER, Katharina, 88161 Lindau (DE)
(74) Vertreter: Thun, Clemens
(86) Internationale Anmeldenummer: PCT/EP2011/074239
(87) Internationale Veröffentlichungsnummer: WO 2012/093065

(56) Entgegenhaltungen:
- WO-A1-01/41215
- WO-A1-2008/052333
- WO-A1-2009/036001
- DE-A1-102007 043 355
- US-A1- 2010 140 633

## Beschreibung

Die Erfindung betrifft eine Anordnung zur Erzeugung von weißem Licht mit einem Trägerelement, einer ersten, auf dem Trägerelement angeordneten LED zur Erzeugung eines roten Lichts und einer zweiten, auf dem Trägerelement angeordneten LED zur Erzeugung eines blauen und/oder ultravioletten Lichts.

Aus dem Stand der Technik ist eine derartige Anordnung bekannt, bei der weiterhin eine dritte LED zur Erzeugung von grünem Licht auf dem Trägerelement angeordnet ist. Mit dieser Anordnung lässt sich weißes Licht erzeugen. Allerdings sind bei dieser bekannten Anordnung jedenfalls wenigstens drei LEDs auf dem Trägerelement angeordnet, so dass die Anordnung von daher eine gewisse Mindestgröße aufweist.

Eine besonders geringe Baugröße einer entsprechenden Anordnung ist in der Regel beispielsweise erwünscht, wenn das von der Anordnung erzeugte Licht mit einem optischen Element gebündelt werden soll bzw. wenn das erzeugte Licht seitlich in einen Lichtleiter eingestrahlt werden soll.

Aus der US 2010/0140633 A1 ist eine LED-Lichtquelle bekannt, die rote LEDs und blaue LEDs aufweist. Das von den blauen LEDs abgegebene Licht wird durch Phosphor beeinflusst, so dass einerseits ein gelb-grünes Licht und andererseits ein weißes Licht entsteht.

Aus der WO 01/41215 A1 ist eine LED-Weißlichtquelle bekannt, die eine rote LED und eine blaue LED aufweist. Dabei wird das von der blauen LED abgegebene blaue Licht durch ein Phosphor-Material teilweise in grünes Licht umgewandelt.

Weitere LED-Lichtquellen sin aus den Schriften DE 10 2007 043 355 A1, WO 2008/052333 A1 und WO 2009/036001 A1 bekannt.

Der Erfindung liegt die Aufgabe zugrunde, eine entsprechende verbesserte Anordnung zur Erzeugung von weißem Licht anzugeben; insbesondere soll die Anordnung effizient sein und gute Farbwiedergabeeigenschaften aufweisen und dabei besonders kompakt gestaltet werden können.

Diese Aufgabe wird gemäß der Erfindung mit dem in dem unabhängigen Anspruch genannten Gegenstand gelöst. Besondere Ausführungsarten der Erfindung sind in den abhängigen Ansprüchen angegeben.

Gemäß der Erfindung ist eine Anordnung zur Erzeugung von weißem Licht vorgesehen, die ein Trägerelement aufweist, eine erste, auf dem Trägerelement angeordnete LED zur Erzeugung eines roten Lichts und eine zweite, auf dem Trägerelement angeordnete LED zur Erzeugung eines blauen und/oder ultravioletten Lichts. Weiterhin weist die Anordnung ein Lichtbeeinflussungselement auf, das derart ausgestaltet und angeordnet ist, dass es wenigstens einen Teil des von der zweiten LED erzeugten Lichts in ein grünes Licht, insbesondere in ein mintgrünes und/oder grünlich weißes Licht umwandelt.

Durch Mischung des roten Lichts mit dem grünen Licht lässt sich effizient ein weißes Licht mit sehr guten Farbwiedergabeeigenschaften erzeugen. Es lässt sich ein Licht erzeugen, dessen Farbort nahe der Planck-Kurve liegt. Dabei kann die Anordnung besonders kompakt gestaltet sein, da lediglich zwei LEDs erforderlich sind.

Erfindungsgemäß weist das Lichtbeeinflussungselement Phosphor-Teilchen auf.

Vorzugsweise ist das Lichtbeeinflussungselement derart ausgestaltet und angeordnet, dass es das von der ersten LED erzeugte Licht zumindest im Wesentlichen nicht farbverändernd beeinflusst und/oder, dass es das von der ersten LED erzeugte Licht zumindest teilweise streut.

Vorteilhaft weist die Anordnung weiterhin erste Kontaktelemente zur elektrischen Kontaktierung der ersten LED und zweite Kontaktelemente zur elektrischen Kontaktierung der zweiten LED auf. Auf diese Weise ist eine getrennte Steuerung der ersten LED und der zweiten LED ermöglicht, so dass ein von der Anordnung abgegebenes Licht in seinem Farbverhalten gezielt verändert werden kann.

Erfindungsgemäß weist die Anordnung weiterhin eine dritte, auf dem Trägerelement angeordnete LED zur Erzeugung eines blauen und/oder ultravioletten Lichts auf, sowie ein zweites Lichtbeeinflussungselement, das derart ausgestaltet und angeordnet ist, dass es wenigstens einen Teil des von der dritten LED erzeugten Lichts in ein Licht einer zweiten anderen Farbe umwandelt, die sich von der zuerst genannten anderen Farbe unterscheidet, und zwar ein weiteres grünes Licht, insbesondere in ein mintgrünes und/oder grünlich weißes Licht. Hierdurch lässt sich mit der Anordnung ein Licht erzeugen, dass in seiner Farbtemperatur unterschiedlich eingestellt werden kann.

Weiterhin vorteilhaft weist die Anordnung weiterhin eine vierte, auf dem Trägerelement angeordnete LED zur Erzeugung eines blauen und/oder ultravioletten

Lichts auf, sowie ein drittes Lichtbeeinflussungselement, das derart ausgestaltet und angeordnet ist, dass es wenigstens einen Teil des von der vierten LED erzeugten Lichts in ein Licht einer dritten anderen Farbe umwandelt, die sich sowohl von der zuerst genannten anderen Farbe als auch von der zweiten anderen Farbe unterscheidet, vorzugsweise in ein grünes Licht, insbesondere in ein mintgrünes und/oder grünlich weißes Licht. Hierdurch werden die Einstellmöglichkeiten des von der Anordnung abgegebenen Lichts weitergehend verbessert.

Vorteilhaft weist die Anordnung weiterhin eine weitere, auf dem Trägerelement angeordnete LED zur Erzeugung eines blauen Lichts auf, wobei die Anordnung kein Lichtbeeinflussungselement zur Umwandlung eines von der weiteren LED erzeugten Lichts in ein Licht einer anderen Farbe aufweist. Hierdurch lässt sich mit der Anordnung ein weißes Licht erzeugen, das über einen weiten Bereich in seiner Farbtemperatur einstellbar ist.

Vorteilhaft weist die Anordnung weiterhin ein lichtstreuendes Element auf, das derart gestaltet und angeordnet ist, dass es ein von den LEDs der Anordnung erzeugtes Licht streut. Hierdurch lässt sich das von den LEDs der Anordnung erzeugte Licht besonders effektiv vermischen.

Vorteilhaft weist die Anordnung weiterhin einen Reflektor auf, der derart gestaltet und um die LEDs der Anordnung angeordnet ist, dass er ein von den LEDs der Anordnung erzeugtes Licht reflektiert. Dies ermöglicht eine gute Durchmischung und eine besonders effiziente Lichtausbeute.

Vorteilhaft weist die Anordnung weiterhin ein farbiges Licht mischendes Linsenfeld-Element auf, das derart gestaltet und angeordnet ist, dass es ein von den LEDs der Anordnung erzeugtes Licht vermischt.

Die Erfindung wird im Folgenden anhand von Ausführungsbeispielen und mit Bezug auf die Zeichnungen näher erläutert. Es zeigen:
- Fig. 1a: eine Querschnittskizze und zu einem ersten Ausführungsbeispiel einer erfindungsgemäßen Anordnung,
- Fig. 1b: eine entsprechende Aufsicht-Skizze,
- Fig. 2: eine Querschnittskizze zu einem zweiten Ausführungsbeispiel einer erfindungsgemäßen Anordnung,
- Fig. 3a: eine Skizzen zu einem dritten Ausführungsbeispiel,
- Fig. 3b: eine Skizze eines Farbdiagramms mit Bezug auf das in Fig. 3a gezeigte Ausführungsbeispiel,
- Fig. 4a: eine Skizzen zu einem vierten Ausführungsbeispiel,
- Fig. 4b: eine Skizze eines Farbdiagramms mit Bezug auf das in Fig. 4a gezeigte Ausführungsbeispiel,
- Fig. 5: eine Skizze zu einem fünften Ausführungsbeispiel,
- Fig. 6: eine Skizze zu einem sechsten Ausführungsbeispiel,
- Fig. 7a: eine Skizze zu einem siebten Ausführungsbeispiel mit einem lichtbrechenden Element und
- Fig. 7b: eine Aufsicht auf das lichtbrechende Element.

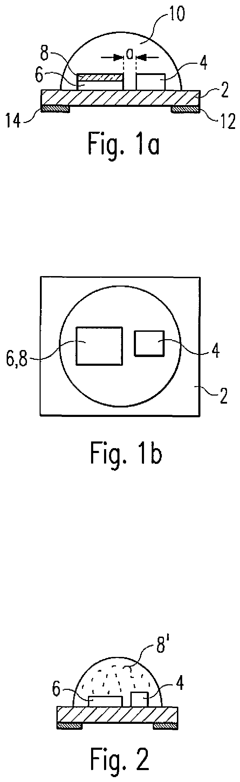

Fig. 1a zeigt sehr schematisch eine Querschnittskizze und Fig. 1b eine entsprechende Aufsicht-Skizze zu einem ersten Ausführungsbeispiel einer erfindungsgemäßen Anordnung zur Erzeugung von weißem Licht. Die Anordnung weist ein Trägerelement 2 auf, eine erste LED 4, die auf dem Trägerelement 2 angeordnet ist und eine zweite LED 6, die ebenfalls auf dem Trägerelement 2 angeordnet ist. Es kann hierdurch eine "Multichip-LED" gebildet sein.

Bei dem Trägerelement 2 kann es sich um eine Platine handeln.

Die erste LED 4 ist dazu ausgestaltet, ein rotes Licht zu erzeugen. Die zweite LED 6 ist dazu ausgestaltet, ein blaues Licht und/oder ein ultraviolettes Licht zu erzeugen.

Weiterhin weist die Anordnung ein Lichtbeeinflussungselement 8 auf, das derart ausgestaltet und angeordnet ist, dass es wenigstens einen Teil des von der zweiten LED 6 erzeugten Lichts in ein grünes Licht umwandelt, insbesondere in ein mintgrünes und/oder grünlich weißes oder weißlich-grünes Licht umwandelt. Insbesondere kann das Lichtbeeinflussungselement, wie an sich bekannt, Phosphor-Teilchen aufweisen.

Die Anordnung ist vorzugsweise derart gestaltet, dass sie ein Licht abgibt, das einer Kombination der von den LEDs 4, 6 der Anordnung abgegebenen Lichter entspricht. Daher sind vorzugsweise die erste LED 4 und die zweite LED 6 derart angeordnet, dass sie nur einen sehr geringen Abstand *a* voneinander aufweisen. Vorteilhaft beträgt der Abstand weniger als 10 mm, besonders bevorzugt weniger als 3 mm.

Vorzugsweise sind die erste LED 4, die zweite LED 6 und das Lichtbeeinflussungselement 8 von einer Silikonabdeckung 10 abgedeckt, die sich insbesondere die genannten Bauteile allseits umfassend bis zu dem Trägerelement 2 hin erstrecken kann.

Vorzugsweise weist die Anordnung erste Kontaktelemente 12 zur elektrischen Kontaktierung der ersten LED 4 auf und getrennt von den ersten Kontaktelementen 12 angeordnete, zweite Kontaktelemente 14 zur elektrischen Kontaktierung der zweiten LED 6. Hierdurch ist eine getrennte Ansteuerung der beiden LEDs 4, 6 ermöglicht, so dass eine Farbe eines Lichts, das von der Anordnung abgegebenen werden kann und das sich aus dem von der ersten LED 4 erzeugten Licht und dem von der zweiten LED 6 erzeugten und dem Lichtbeeinflussungselement 8 umgewandelten Licht zusammensetzt, verändert werden kann. Dementsprechend umfasst die Anordnung weiterhin vorteilhaft eine Steuereinheit zur getrennten Ansteuerung der ersten LED 4 und der zweiten LED 6. Insbesondere kann vorgesehen sein, dass sich die erste LED 4 und die zweite LED 6 unabhängig voneinander dimmen lassen.

Wie in der Aufsicht der Fig. 1b exemplarisch gezeigt, umfasst gemäß dem hier gezeigten Ausführungsbeispiel die Anordnung lediglich die zwei genannten LEDs 4, 6. Sie lässt sich daher sehr kompakt gestalten. Dies ist beispielsweise vorteilhaft, wenn mit der Anordnung ein Licht erzeugt werden soll, das im Weiteren durch ein optisches Element gebündelt werden soll oder ein Licht, das seitlich in einen Lichtleiter eingekoppelt werden soll.

Die Anordnung lässt sich dementsprechend im Vergleich zu anderen LED-Anordnungen zur Erzeugung von weißem Licht mit besonders wenigen Kontaktelementen bzw. Anschlüssen gestalten.

Wie in Fig. 1 exemplarisch skizziert, kann das Lichtbeeinflussungselement 8 derart ausgestaltet und angeordnet ist, dass es das von der ersten LED 4 erzeugte Licht zumindest im Wesentlichen nicht farbverändernd beeinflusst. Beispielsweise kann das Lichtbeeinflussungselement 8 lediglich auf der lichtabgebenden Oberfläche der zweiten LED 6 flächig aufgebracht sein; es kann also durch eine entsprechende farbumwandelnde Schicht auf der zweiten LED 6 gegeben sein.

Es kann in einer Variation auch vorgesehen sein, dass die Anordnung mehrere entsprechende erste LEDs aufweist, die rotes Licht erzeugen und/oder mehrere entsprechende zweite LEDs, die blaues und/oder ultraviolettes Licht erzeugen, wobei das Lichtbeeinflussungselement jede der zweiten LEDs entsprechend beeinflusst oder jede der zweiten LEDs jeweils ein entsprechendes Lichtbeeinflussungselement aufwei st.

In Fig. 2 ist eine Skizze zu einem zweiten Ausführungsbeispiel gezeigt. Soweit nicht anders angegeben, gelten die Ausführungen zum ersten Ausführungsbeispiel analog auch für das zweite Ausführungsbeispiel.

Beim zweiten Ausführungsbeispiel ist das Lichtbeeinflussungselement 8' derart ausgestaltet und angeordnet ist, dass es das von der ersten LED 6 erzeugte Licht zumindest teilweise streut. Es kann hierzu vorgesehen sein, dass das Lichtbeeinflussungselement 8' in der Silikonabdeckung 10, vorzugsweise gleichmäßig bzw. homogen verteilt, integriert ist.

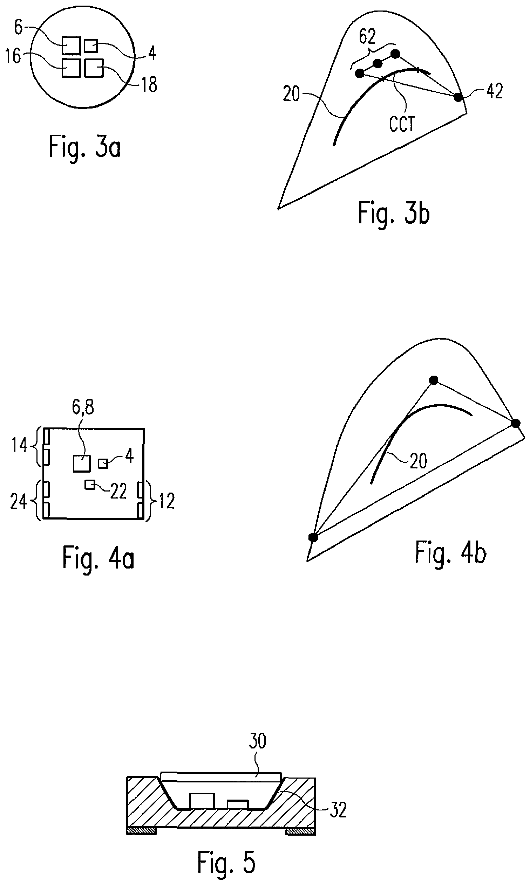

In Fig. 3a ist eine Skizze zu einem dritten Ausführungsbeispiel gezeigt; wiederum wird nur auf die Unterschiede zu der obigen Darstellung eingegangen. Bei diesem Ausführungsbeispiel weist die Anordnung weiterhin eine dritte, auf dem Trägerelement angeordnete LED 16 zur Erzeugung eines blauen und/oder ultravioletten Lichts und ein zweites Lichtbeeinflussungselement auf, das derart ausgestaltet und angeordnet ist, dass es wenigstens einen Teil des von der dritten LED 16 erzeugten Lichts in ein Licht einer zweiten anderen Farbe umwandelt, die sich von der zuerst genannten anderen Farbe unterscheidet, vorzugsweise in ein grünes Licht, insbesondere in ein mintgrünes und/oder grünlich weißes Licht. Ansonsten kann das zweite Lichtbeeinflussungselement insbesondere analog zu dem zuerst genannten Lichtbeeinflussungselement 8 gestaltet und angeordnet sein. Insbesondere kann das zweite Lichtbeeinflussungselement zweite Phosphor-Teilchen aufweisen, die sich in ihren optischen Eigenschaften von den Phosphor-Teilchen des zuerst genannten Lichtbeeinflussungselements 8 unterscheiden.

Weiterhin kann in analoger Weise noch eine vierte LED 18 zur Erzeugung eines blauen und/oder ultravioletten Lichts und ein dementsprechendes drittes Lichtbeeinflussungselement vorgesehen sein, das wiederum analog derart ausgestaltet und angeordnet ist, dass es wenigstens einen Teil des von der vierten LED 18 erzeugten Lichts in ein Licht einer dritten anderen Farbe umwandelt, die sich sowohl von der zuerst genannten anderen Farbe als auch von der zweiten anderen Farbe unterscheidet, vorzugsweise in ein grünes Licht, insbesondere in ein mintgrünes und/oder grünlich weißes Licht.

Vorzugswise sind die genannten LEDs 4, 6, 16 und gegebenenfalls 18 wiederum getrennt voneinander steuerbar. Auf diese Weise lässt sich mit der Anordnung ein weißes Licht erzeugen, dessen Farbtemperatur in einem bestimmten Bereich eingestellt werden kann; hierzu ist in Fig. 3b schematisch ein Farbdiagramm skizziert, das zum einen den Farbort 42 des von der ersten LED 4 erzeugten roten Lichts zeigt und zum anderen die drei Farborte 62 der von den drei Lichtbeeinflussungselementen umgewandelten Lichter. Weiterhin ist die Planck-Kurve 20 skizziert. Durch entsprechende Ansteuerung der LEDs 4, 6, 16, 18 lässt sich Licht in jeder Farbtemperatur *CCT* erzeugen, die einerseits auf der Planck-Kurve 20 liegt und dabei andererseits innerhalb der von den genannten Farborten 42, 62 aufgespannten Fläche liegt.

In Fig. 4a ist eine Skizze zu einem vierten Ausführungsbeispiel gezeigt. Wiederum wird nur auf die Unterschiede zu den obigen Darstellungen eingegangen. Bei diesem Ausführungsbeispiel weist die Anordnung weiterhin eine weitere, auf dem Trägerelement angeordnete LED 22 zur Erzeugung eines blauen Lichts auf, wobei die Anordnung kein Lichtbeeinflussungselement zur Umwandlung eines von der weiteren LED 22 erzeugten Lichts in ein Licht einer anderen Farbe aufweist. Wie in Fig. 4b skizziert, lässt sich hierdurch mit der Anordnung ein weißes Licht erzeugen, das in einem weiten Bereich in seiner Farbtemperatur eingestellt werden kann, beispielsweise zwischen 2700 K und 6500 K. Dementsprechend vorteilhaft sind die LEDs wiederum unabhängig voneinander ansteuerbar, so dass dementsprechend vorzugsweise dritte Kontaktelemente 24 zur elektrischen Kontaktierung der weiteren LED 22 vorgesehen sind.

In Fig. 5 ist ein fünftes Ausführungsbeispiel skizziert, bei dem die Anordnung gemäß den obigen Darstellungen gestaltet sein kann und weiterhin ein lichtstreuendes Element 30 aufweist, das derart gestaltet und angeordnet ist, dass es ein von den LEDs 4, 6, 16, 18, 22 der Anordnung erzeugtes Licht streut. Bei dem lichtstreuenden Element 30 kann es sich insbesondere um einen hocheffizienten Diffusor handeln.

Außerdem kann die Anordnung weiterhin einen Reflektor 32 aufweisen, der derart gestaltet und um die LEDs 4, 6, 16, 18, 22 der Anordnung angeordnet ist, dass er ein von den LEDs 4, 6, 16, 18, 22 der Anordnung erzeugtes Licht reflektiert. Hierdurch wird die Durchmischung der von den LEDs 4, 6, 16, 18, 22 abgegebenen Lichter weitergehend forciert. Der Reflektor 32 kann beispielsweise eine weiße Oberfläche aufweisen, spiegelnd gestaltet sein und/oder aus Keramik bestehen.

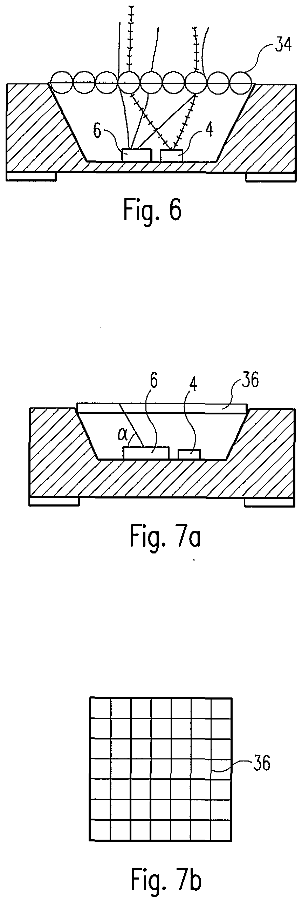

In Fig. 6 ist ein sechstes Ausführungsbeispiel skizziert, bei dem die Anordnung weiterhin ein farbiges Licht mischendes Linsenfeld-Element 34 aufweist, das derart gestaltet und angeordnet ist, dass es ein von den LEDs 4, 6, 16, 18, 22 der Anordnung erzeugtes Licht vermischt.

Anstelle des Linsenfeld-Elements 34 kann auch ein in Fig. 7a beispielhaft skizziertes, lichtbrechendes Element 36 vorgesehen sein. Fig. 7b zeigt eine Aufsicht auf das lichtbrechende Element 36. Das lichtbrechende Element 36 weist Pixel für das rote und das grünliche Licht auf, wobei die Struktur des Elements 36 bzw. der Pixel von dem in Fig. 7a skizzierten Winkel *α* abhängig ist.

Die erfindungsgemäße Anordnung zur Erzeugung weißen Lichts weist insbesondere eine hohe Effizienz auf und generiert Licht mit einem hohen Farbwiedergabeindex. Außerdem lässt sich die Anordnung besonders kompakt gestalten, einfach in der Ansteuerung und weiterhin so, dass Licht mit unterschiedlichen Farbtemperaturen erzeugt werden kann.

## Patentansprüche

1. Anordnung zur Erzeugung von weißem Licht, aufweisend
- ein Trägerelement (2),
- eine erste, auf dem Trägerelement (2) angeordnete LED (4) zur Erzeugung eines roten Lichts,
- eine zweite, auf dem Trägerelement (2) angeordnete LED (6) zur Erzeugung eines blauen und/oder ultravioletten Lichts,
- ein Lichtbeeinflussungselement (8), das derart ausgestaltet und angeordnet ist, dass es wenigstens einen Teil des von der zweiten LED (6) erzeugten Lichts in ein grünes Licht, insbesondere in ein mintgrünes und/oder grünlich weißes Licht umwandelt,
- eine dritte, auf dem Trägerelement (2) angeordnete LED (16) zur Erzeugung eines blauen und/oder ultravioletten Lichts,
- ein zweites Lichtbeeinflussungselement, das derart ausgestaltet und angeordnet ist, dass es wenigstens einen Teil des von der dritten LED (16) erzeugten Lichts in ein Licht einer zweiten anderen Farbe umwandelt, die sich von der zuerst genannten anderen Farbe unterscheidet, und zwar in ein weiteres grünes Licht, das sich in seiner Farbe von dem zuerst genannten grünen Licht unterscheidet,
wobei das Lichtbeeinflussungselement (8) Phosphor-Teilchen aufweist, **dadurch gekennzeichnet,**
**dass** das zweite Lichtbeeinflussungselement zweite Phosphor-Teilchen aufweist, die sich in ihren optischen Eigenschaften von den Phosphor-Teilchen des zuerst genannten Lichtbeeinflussungselements (8) unterscheiden.

2. Anordnung nach Anspruch 1,
bei der das Lichtbeeinflussungselement (8, 8') derart ausgestaltet und angeordnet ist, dass es das von der ersten LED (4) erzeugte Licht zumindest im Wesentlichen nicht farbverändernd beeinflusst und/oder bei der das Lichtbeeinflussungselement (8, 8') derart ausgestaltet und angeordnet ist, dass es das von der ersten LED (4) erzeugte Licht zumindest teilweise streut.

3. Anordnung nach einem der vorhergehenden Ansprüche,
weiterhin aufweisend
- erste Kontaktelemente (12) zur elektrischen Kontaktierung der ersten LED (4) und
- zweite Kontaktelemente (14) zur elektrischen Kontaktierung der zweiten LED (6).

4. Anordnung nach einem der vorhergehenden Ansprüche,
wobei das Licht der zweiten anderen Farbe ein mintgrünes und/oder grünlich weißes Licht ist.

5. Anordnung nach einem der vorhergehenden Ansprüche,
weiterhin aufweisend
- eine vierte, auf dem Trägerelement (2) angeordnete LED (18) zur Erzeugung eines blauen und/oder ultravioletten Lichts und
- ein drittes Lichtbeeinflussungselement, das derart ausgestaltet und angeordnet ist, dass es wenigstens einen Teil des von der vierten LED (18) erzeugten Lichts in ein Licht einer dritten anderen Farbe umwandelt, die sich sowohl von der zuerst genannten anderen Farbe als auch von der zweiten anderen Farbe unterscheidet, vorzugsweise in ein grünes Licht, insbesondere in ein mintgrünes und/oder grünlich weißes Licht.

6. Anordnung nach einem der vorhergehenden Ansprüche,
weiterhin aufweisend
- eine weitere, auf dem Trägerelement (2) angeordnete LED (22) zur Erzeugung eines blauen Lichts, wobei die Anordnung kein Lichtbeeinflussungselement zur Umwandlung eines von der weiteren LED (22) erzeugten Lichts in ein Licht einer anderen Farbe aufweist.

7. Anordnung nach einem der vorhergehenden Ansprüche,
weiterhin aufweisend
- ein lichtstreuendes Element (30), das derart gestaltet und angeordnet ist, dass es ein von den LEDs (4, 6, 16, 18, 22) der Anordnung erzeugtes Licht streut.

8. Anordnung nach einem der vorhergehenden Ansprüche,
weiterhin aufweisend
- einen Reflektor (32), der derart gestaltet und um die LEDs (4, 6, 16, 18, 22) der Anordnung angeordnet ist, dass er ein von den LEDs (4, 6, 16, 18, 22) der Anordnung erzeugtes Licht reflektiert.

9. Anordnung nach einem der vorhergehenden Ansprüche,
weiterhin aufweisend
- ein farbiges Licht mischendes Linsenfeld-Element (34), das derart gestaltet und angeordnet ist, dass es ein von den LEDs (4, 6, 16, 18, 22) der Anordnung erzeugtes Licht vermischt.

## Claims

1. An arrangement for generating white light, having
- support element (2),
- a first LED (4) arranged on the support element (2) for generating a red light,
- a second LED (6) arranged on the support element (2) for generating a blue and/or ultraviolet light,
- a light-influencing element (8), which is designed and arranged in such a manner that it converts at least a portion of the light generated by the second LED (6) into a green light, in particular into a mint green and/or greenish white light,
- a third LED (16) arranged on the support element (2) for generating a blue and/or ultraviolet light,
- a second light-influencing element, which is designed and arranged in such a manner that it converts at least a portion of the light generated by the third LED (16) into a light of a second different color, specifically into a further green light, which differs in its color from the first-mentioned green light,
wherein the light-influencing element (8) has phosphorus particles, **characterized in**
**that** the second light-influencing element has second phosphorus particles, which differ in their optical properties from the phosphorus particles of the first-mentioned light-influencing element (8).

2. An arrangement according to Claim 1,
in which the light-influencing element (8, 8') is designed and arranged in such a manner that it influences the light generated by the first LED (4) at least substantially in a non-color changing manner and/or in which the light-influencing element (8, 8') is designed and arranged in such a manner that it at least partially scatters the light generated by the first LED (4).

3. An arrangement according to any one of the preceding claims,
furthermore having
- first contact elements (12) for electrically contacting the first LED (4) and
- second contact elements (14) for electrically contacting the second LED (6).

4. An arrangement according to any one of the preceding claims,
wherein the light of the second different color is a mint green and/or greenish white light.

5. An arrangement according to any one of the preceding claims,
furthermore having,
- a fourth LED (18) arranged on the support element (2) for generating a blue and/or ultraviolet light and
- a third light-influencing element, which is designed and arranged in such a manner that it converts at least a portion of the light generated by the fourth LED (18) into a light of a third different color, which differs both from the first-mentioned different color as well as from the second different color, preferably into a light, in particular into a mint green and/or greenish white light.

6. An arrangement according to any one of the preceding claims,
furthermore having
- a further LED (22) arranged on the support element (2) for generating a blue light, wherein the arrangement has no light-influencing element for converting a light generated by the further LED (22) into a light of a different color.

7. An arrangement according to any one of the preceding claims,
furthermore having
- a light-scattering element (30), which is designed and arranged in such a manner that it scatters a light generated by the LEDs (4, 6, 16, 18, 22) of the arrangement.

8. An arrangement according to any one of the preceding claims,
furthermore having
- a reflector (32) which is designed and is arranged around the LEDs (4, 6, 16, 18, 22) of the arrangement in such a manner that it reflects a light generated by the LEDs (4, 6, 16, 18, 22) of the arrangement.

9. An arrangement according to any one of the preceding claims,
furthermore having
- a colored light-mixing lens-field element (34), which is designed and arranged in such a manner that it mixes a light generated by the LEDs (4, 6, 16 18, 22) of the arrangement.

## Revendications

1. Dispositif de production d'une lumière blanche comprenant :
- un élément de support (2),
- une première LED (4) disposée sur l'élément de support (2) pour la production d'une lumière rouge,
- une deuxième LED (6) disposée sur l'élément de support (2) pour la production d'une lumière bleue et/ou ultraviolette,
- un élément de contrôle de la lumière (8) conçu et disposé de façon à convertir au moins une partie de la lumière produite par la deuxième LED (6) en une lumière verte, plus particulièrement en une lumière vert menthe et/ou verdâtre blanche,
- une troisième LED (16) disposée sur l'élément de support (2) pour la production d'une lumière bleue et/ou ultraviolette,
- un deuxième élément de contrôle de la lumière conçu et disposé de façon à convertir au moins une partie de la lumière produite par la troisième LED (16) en une lumière d'une deuxième couleur différente, qui se distingue de l'autre couleur déjà mentionnée, à savoir en une autre lumière verte, qui se distingue, en ce qui concerne sa couleur, de la lumière verte déjà mentionnée,
l'élément de contrôle de la lumière (8) comprenant des particules de phosphore,
**caractérisé en ce que**
le deuxième élément de contrôle de la lumière comprend des deuxièmes particules de phosphore qui se distinguent, en ce qui concerne leurs propriétés optiques, des particules de phosphore de l'élément de contrôle de la lumière (8) déjà mentionné.

2. Dispositif selon la revendication 1,
dans lequel l'élément de contrôle de la lumière (8, 8') est conçu et disposé de façon à contrôler la lumière produite par la première LED (4) au globalement sans changer la couleur et/ou dans lequel l'élément de contrôle de la lumière (8, 8') est conçu et disposé de façon à diffuser au moins partiellement la lumière produite par la première LED (4).

3. Dispositif selon l'une des revendications précédentes, comprenant en outre
- des premiers éléments de contact (12) pour le contact électrique de la première LED (4) et
- des deuxièmes éléments de contact (14) pour le contact électrique de la deuxième LED (6).

4. Dispositif selon l'une des revendications précédentes,
la lumière de la deuxième couleur différente est une lumière vert menthe et/ou verdâtre blanche.

5. Dispositif selon l'une des revendications précédentes, comprenant en outre
- une quatrième LED (18) disposée sur l'élément de support (2) pour la production d'une lumière bleue et/ou ultraviolette et
- un troisième élément de contrôle de la lumière conçu et disposé de façon à convertir au moins une partie de la lumière produite par la quatrième LED (18) en une lumière d'une troisième couleur différente, qui se distingue aussi bien de la couleur déjà mentionnée que de la deuxième couleur différente, de préférence en une lumière verte, plus particulièrement en une lumière vert menthe et/ou une lumière verdâtre blanche.

6. Dispositif selon l'une des revendications précédentes, comprenant en outre
- une autre LED (22) disposée sur l'élément de support (2) pour la production d'une lumière bleue, le dispositif ne comprenant aucun élément de contrôle de la lumière pour la conversion d'une lumière produite par l'autre LED (22) en une lumière d'une autre couleur.

7. Dispositif selon l'une des revendications précédentes, comprenant en outre
- un élément de diffusion de lumière (30) conçu et disposé de façon à diffuser la lumière produite par une des LED (4, 6, 16, 18, 22) du dispositif.

8. Dispositif selon l'une des revendications précédentes, comprenant en outre
- un réflecteur (32) conçu et disposé autour des LED (4, 6, 16, 18, 22) du dispositif de façon à réfléchir une lumière produite par une des LED (4, 6, 16, 18, 22) du dispositif.

9. Dispositif selon l'une des revendications précédentes, comprenant en outre
- un élément à champ de lentilles (34) mélangeant une lumière colorée, conçu et disposé de façon à mélanger une lumière produite par une des LED (4, 6, 16, 18, 22) du dispositif.
